# EUROPÄISCHE PATENTSCHRIFT

(11) **EP 0 614 539 B1**
(45) Veröffentlichungstag und Bekanntmachung des Hinweises auf die Patenterteilung: **17.12.1997**
(21) Anmeldenummer: 93918939.5
(22) Anmeldetag: 04.09.1993
(51) Int. Cl.: G02B 6/42, G02B 6/12

(54) **VERFAHREN ZUM HERSTELLEN EINES DECKELS FÜR EINE INTEGRIERT OPTISCHE SCHALTUNG**
METHOD OF PRODUCING A COVER FOR AN OPTICAL INTEGRATED CIRCUIT
PROCEDE DE FABRICATION D'UN COUVERCLE POUR UN CIRCUIT OPTIQUE INTEGRE

(30) Priorität: 29.09.1992 DE 4232608
(43) Veröffentlichungstag der Anmeldung: 14.09.1994
(73) Patentinhaber: ROBERT BOSCH GMBH, 70442 Stuttgart (DE)
(72) Erfinder: KRAGL, Hans, D-64372 Ober-Ramstadt (DE); RECH, Wolf-Henning, D-64347 Griesheim (DE); WEHMANN, Hergo-Heinrich, D-38527 Meine (DE)
(86) Internationale Anmeldenummer: DE9300800
(87) Internationale Veröffentlichungsnummer: WO9408263

(56) Entgegenhaltungen:
- EP-A- 0 313 956
- EP-A- 0 331 338
- EP-A- 0 495 559
- FR-A- 2 226 754
- US-A- 4 107 242
- PATENT ABSTRACTS OF JAPAN vol. 8, no. 248 (P-313)(1685) 14. November 1984 & JP,A,59 121 008 (TOUKIYOU KOGYO DAIGAKU)
- PATENT ABSTRACTS OF JAPAN vol. 9, no. 174 (P-374)(1897) 19. Juni 1985 & JP,A,60 049 304 (FUJITSU)
- LEOS' 90, Boston, Massachusetts, 4.-9. November 1990, Proceedings, Band 2, IEEE, New York, G. E. BLONDER: 'Silicon Optical Bench Research at AT&T

## Beschreibung

### Stand der Technik

Die Erfindung geht aus von einem Verfahren zum Herstellen eines Deckels für eine integriert optische Schaltung nach der Gattung des Hauptanspruchs.

Aus der Patentanmeldung DE-P 42 12 208.2 ist bereits ein Verfahren zur Herstellung optischer Polymer-Bauelemente mit integrierter Faser-Chip-Kopplung in Abformtechnik bekannt. Dabei wird zur Einkopplung einer integriert optischen Schaltung zwischen zwei Glasfasern ein Polymer-Substrat mittels einer Masterstruktur so geformt, daß die Glasfasern in einer V-förmigen Nut im Substrat zu liegen kommen. Ihre Längsachse fluchtet dabei mit der Längsachse eines im Substrat zwischen den V-förmigen Nuten angeordneten Lichtwellenleitergrabens. Durch Auffüllen der Nuten und des Lichtwellenleitergrabens mit Polymer-Klebstoff wird mit dem Auflegen eines Polymer-Deckels sowohl eine mechanisch feste Verbindung von Substrat und Deckel als auch eine optische Kopplung der Glasfasern an den aus dem Polymer-Klebstoff gebildeten Lichtwellenleiter gewährleistet.

Des weiteren ist aus dem Artikel "Channel glass wave guide detectors with grafted GaAs film in embedded configuration" in Electronic Letters 27 (1991), Seiten 410 bis 412 von Chan, Yi-Yan, et al. bekannt, auf einem Glas-Substrat einen aufgepfropften Photodetektor an einen im Substrat befindlichen Lichtwellenleiter evaneszent anzukoppeln. Dieses Herstellungsverfahren erfordert eine präzise Justage des Wellenleiters und des Photodetektors zueinander, die für jedes Bauteil individuell durchgeführt werden muß und ein kompliziertes Justierverfahren beinhaltet.

Umhüllen von Bauteilen ist z.B. auch aus US-A-4,107,242 bekannt.

### Vorteile der Erfindung

Das erfindungsgemäße Verfahren mit den kennzeichnenden Merkmalen des Hauptanspruchs hat demgegenüber den Vorteil, daß ein Deckel für eine integriert optische Schaltung mit äußerst geringem Justieraufwand hergestellt werden kann. Weiter besteht der Vorteil, daß das erfindungsgemäße Verfahren besonders für die Massenfertigung geeignet ist, da das Justierprinzip automatisierbar ist und mehrere Deckel für integriert optische Schaltungen gleichzeitig , als auch mehrere integriert optische Schaltungen in einem Deckel zusammen auf einmal hergestellt werden können.

Durch die in den Unteransprüchen genannten Maßnahmen sind vorteilhafte Weiterbildungen und Verbesserungen des im Hauptanspruch angegebenen Verfahres möglich.

Besonders vorteilhaft ist die Ausbildung der Justierelemente und des optischen Bauelements mit teilweise schrägen Seitenflächen, wodurch selbst bei geringfügigen Dejustierungen das optische Bauelement durch die Schwerkraft selbsttätig lateral justiert wird. Weiterhin vorteilhaft ist die Anbringung von weiteren Justierelementen, welche ebenfalls selbsttätig einer vertikalen Justierung des optischen Bauelements dienen.

Erhebungen, welche eine Bragg-Struktur im Deckel zurücklassen, führen den Vorteil mit sich, daß bereits bei der Herstellung des Deckels Bragg-Strukturen mit hergestellt werden. Die Kontaktierung der Chipkontakte durch beim erfindungsgemäßen Herstellungsprozeß entstehende Aussparungen erspart in vorteilhafter Weise einen zusätzlichen Verfahrensschritt. Die Verwendung einer Trägerplatte erleichtert zum einen die Handhabung des optischen Bauelements und erlaubt zum anderen die gleichzeitige Herstellung mehrerer Systeme desselben Typs. Die Verwendung einer Zusatzplatte steigert in vorteilhafter Weise die mechanische Stabilität der Gesamtanordnung.

Der erfindungsgemäße Deckel ist insbesondere mit dem erfindungsgemäßen Verfahren hergestellt. V-förmige Nuten erleichtern das Ankoppeln von Glasfasern an ein den Deckel enthaltendes System. Das Herstellungsverfahren eignet sich besonders für die Integration von integrierten Photodetektoren, als auch von thermischen Aktoren, da hier eine besonders exakte Justierung erforderlich ist, welche durch das erfindungsgemäße Verfahren besonders aufwandsarm realisiert wird.

Der erfindungsgemäße Deckel eignet sich besonders für die Anwendung in einer integriert optischen Schaltung, wobei der Lichtwellenleiter in vorteilhafter Weise bei der Verbindung des Deckels mit einem Substrat durch den Kleber, welcher eine Nut im Substrat füllt, gebildet wird.

### Zeichnung

Ausführungsbeispiele der Erfindung sind in der Zeichnung dargestellt und in der nachfolgenden Beschreibung näher erläutert. Es zeigen:
Figur 1 eine perspektivische aufgebrochene Darstellung einer integriert optischen Schaltung mit Substrat, Deckel und Glasfasern,
Figur 2 eine perspektivische Darstellung des Formstempels und des einzulegenden Photodetektors,
Figur 3 einen Querschnitt durch den Formstempel mit eingelegtem Photodetektor, wobei der Photodetektor breiter als der Abstand der Justierelemente ist,
Figur 4 einen Querschnitt durch den Formstempel mit eingelegtem Photodetektor, wobei der Photodetektor schmäler als der Abstand der Justierelemente ist,
Figur 5 einen Querschnitt durch eine integriert optische Schaltung mit Substrat und aufgesetztem Deckel mit Photodetektor und Zusatzplatte,
Figur 6 eine untere Draufsicht auf den thermischen Aktor,
Figur 7 einen Querschnitt durch eine integriert optische Schaltung mit Substrat und aufgesetztem Deckel mit thermischem Aktor,
Figur 8 eine perspektivische Darstellung des Formstempels zur Herstellung des Deckels mit thermischem Aktor.

### Beschreibung der Ausführungsbeispiele

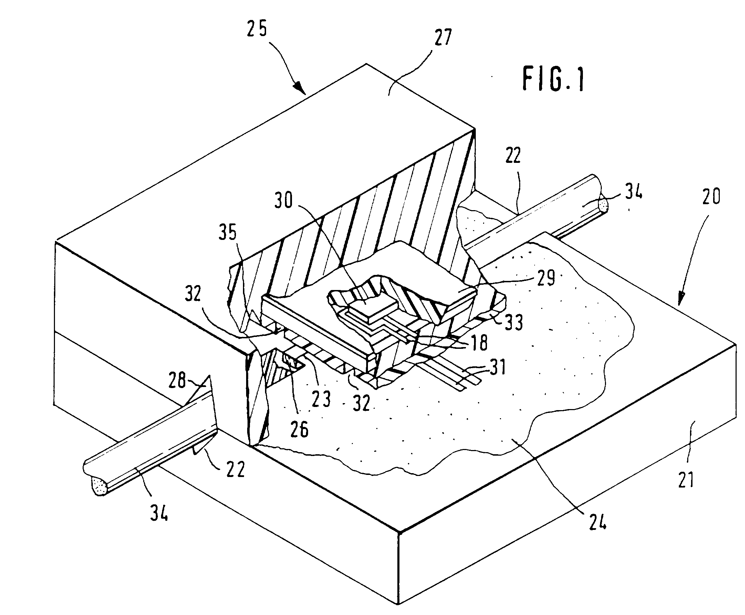

Figur 1 zeigt eine perspektivische aufgebrochene Darstellung einer integriert optischen Schaltung mit einem Substrat 20, einem Deckel 25 und Glasfasern 34. Das Substrat 20 besteht vorzugsweise aus einem Polymer (z.B. Plexiglas) und umfaßt eine Bodenplatte 21, welche zwei miteinander fluchtende V-förmige Nuten 22 sowie eine zwischen den V-förmigen Nuten 22 liegende Nut 23, deren Längsachse ebenfalls mit der Längsachse der V-förmigen Nuten 22 fluchtet, mit rechteckigem Querschitt aufweist. Das Substrat 20 ist mittels eines optisch transparenten Klebers 24 mit dem Deckel 25 verbunden. Der Kleber 24 ist vorzugsweise ebenfalls ein Polymer. Der Kleber 24 füllt außerdem die Nut 23 und bildet so einen Lichtwellenleiter 26. Der Deckel 25 umfaßt eine Deckelplatte 27, die an ihrere Unterseite zwei weitere V-förmige Nuten 28 aufweist, welche bei aufgeklebtem Deckel 25 genau über den V-förmigen Nuten 22 des Substrats 20 zu liegen kommen. Des weiteren ist in der Deckelplatte 27 ein optisches Bauelement 29 angebracht. Beispielhaft sei das optische Bauelement 29 ein Photodetektor, der an seiner Unterseite eine Absorptionszone 30 aufweist. Der Photodetektor 29 liegt nur von einer dünnen Teilschicht 33 der Deckelplatte 27 vom Substrat 20 getrennt und kommt bei aufgeklebtem Deckel 25 mit der Absorptionszone 30 direkt über dem Lichtwellenleiter 26 zu liegen. Zwei Verbindungsleitungen 31 verlaufen zwischen dem Substrat 20 und dem Deckel 25 und setzen sich durch eine von zwei quaderförmigen Aussparungen 32, welche in der Teilschicht 33 unter dem Photodetektor 29 parallel zum Lichtwellenleiter 26 je rechts und links äquidistant liegen, fort, wo sie mit zwei elektrischen Kontakten 18 leitfähig verbunden sind. Die elektrischen Kontakte 18 verlaufen zwischen der Teilschicht 33 und dem Photodetektor 29 bis zur Absorptionszone 30, wo sie zur Kontaktierung der Absorptionszone 30 dienen. In die V-förmigen Nuten 22 und 28 ist von je einer Seite eine Glasfaser 34 eingeführt. An seiner Unterseite weist der Deckel 25 außerdem vier invers-eckdachförmige Vertiefungen 35 auf, welche ebenfalls mit dem Kleber 24 gefüllt sind und an je einem Eck des Photodetektors 29 angeordnet sind.

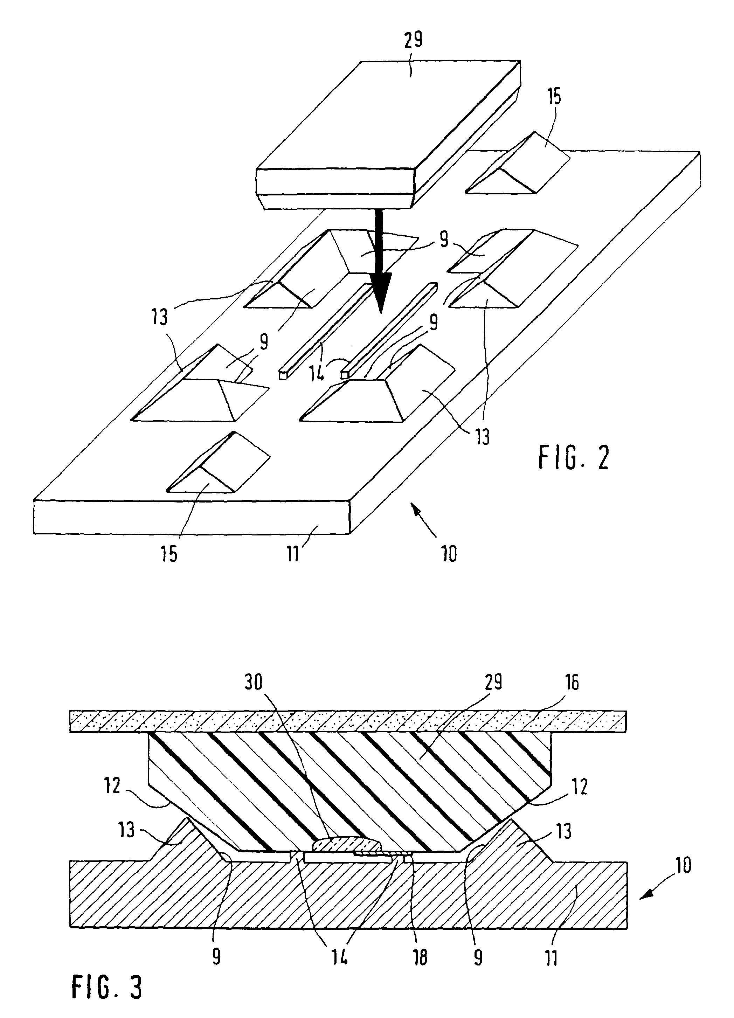

Der Photodetektor 29 ist in dieser Anordnung evaneszent an den Lichtwellenleiter 26 angekoppelt. Durch die Glasfaser 34 laufendes Licht setzt seinen Weg durch den Lichtwellenleiter 26 fort und gelangt wieder in die weiterführende Glasfaser 34. Der Lichtwellenleiter 26, welcher aus dem Kleber 24 gebildet wird, besitzt einen höheren Brechungsindex als die Materialien für die Deckelplatte 27 und die Bodenplatte 21, der möglichst gleich dem Brechungsindex der Glasfasern 34 sein sollte, um optische Verluste gering zu halten. Der Photodetektor 29 ist geeignet, Licht im Lichtwellenleiter 26 zu detektieren und ein daraus resultierendes Detektionssignal an die Verbindungsleitungen 31 abzugeben. Der Photodetektor 29 ist daher so positioniert, daß die Absorptionszone 30 genau über dem Lichtwellenleiter 26 zu liegen kommt. Dazu ist eine präzise Justierung der Anordnung bei ihrem Zusammenbau nötig. Das erfindungsgemäße Verfahren löst diese Aufgabe durch einen selbstjustierenden Herstellungsprozeß des Deckels 25. Dazu wird der Photodetektor 29 zum Einbinden in den Deckel 25 über einen Formstempel 10 justiert (vgl. Fig.2). Die Herstellung des Deckels 25 mit dem darin integrierten Photodetektor 29 erfolgt über das Eingießen einer aushärtbaren Flüssigkeit in die Anordnung aus Formstempel 10 und Photodetektor 29. Diese aushärtbare Flüssigkeit sei beispielhaft ein Flüssig-Polymer. Nach dem Aushärten wird der Formstempel 10 entfernt.

In Figur 2 ist der Formstempel 10 zur Herstellung des Deckels 25 dargestellt. Er umfaßt eine Grundplatte 11, auf der zwei dachförmige Erhebungen 15 sowie vier Justierelemente 13 in Form von eckdachförmigen Erhebungen angebracht sind, die somit schräge Seitenflächen 9 aufweisen. Die vier Justierelemente 13 bilden die vier Ecken eines Rechtecks, während die dachförmigen Erhebungen 15 in ihrer Firstlinie fluchten und die Firstlinie das Rechteck mittig schneidet und die dachförmigen Erhebungen 15 außerhalb des Rechtecks auf je einer Seite liegen. Parallel zur Firstlinie weist der Formstempel 10 außerdem zwei quaderförmige weitere Justierelemente 14 auf, welche innerhalb des Rechtecks liegen und je links und rechts äquidistant der Firstlinie liegen und die Funktion von Abstandsleisten haben.

Die Justierelemente 13 dienen der lateralen Zentrierung und Aufnahme des Photodetektors 29, dessen Unterseite dabei auf den quaderförmigen weiteren Justierelementen 14 zu liegen kommt, wodurch der Photodetektor 29 vertikal justiert wird. Der Formstempel 10 ist idealerweise aus Nickel in einem Galvanikprozeß hergestellt.

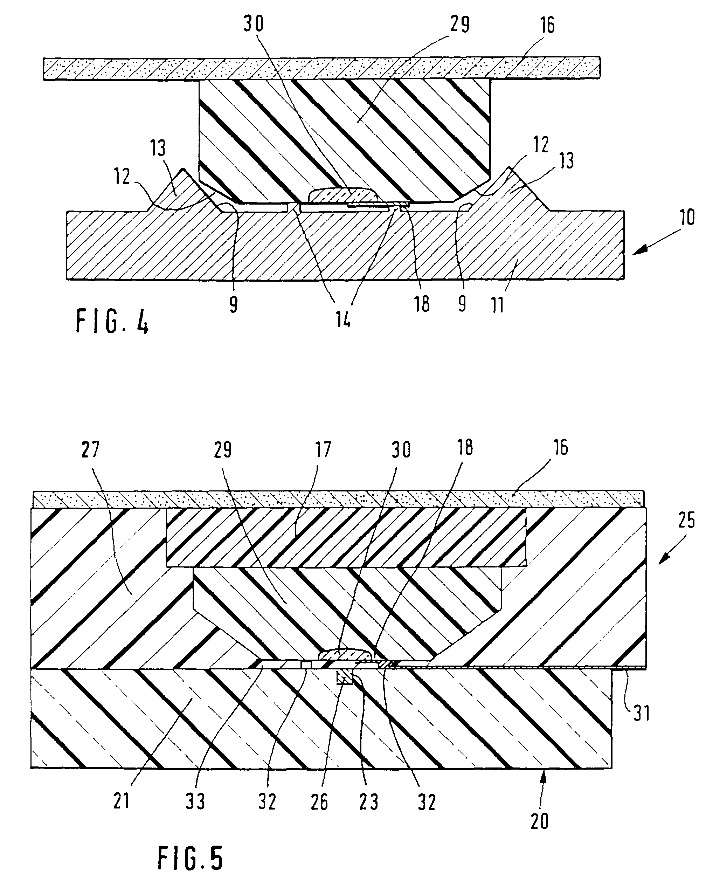

Figur 3 und Figur 4 zeigen je einen Querschnitt durch eine Anordnung aus Formstempel 10 und eingelegtem Photodetektor 29 beim erfindungsgemäßen Verfahren der Herstellung des Deckels 25. Der Photodetektor 29 ist mit seiner Oberseite an einer Trägerplatte 16 befestigt. Für die Wahl des Trägerplattenmaterials ist beispielsweise Kupfer, Silizium, Teflon oder Keramik geeignet. Zu allen vier Seiten ist der Photodetektor 29 teilweise nach unten abgeschrägt, d.h. der Photodetektor 29 besitzt vier weitere schräge Seitenflächen 12, im folgenden Fasen genannt. Die Steigung der Fasen 12 ist geringer als die der schrägen Seitenflächen 9 der Justierelemente 13. Je nach den Abmessungen der Fasen 12 und der Justierelemente 13 kommt der Photodetektor 29 unterschiedlich auf dem Formstempel 10 zu liegen: Sind die Fasen 12 höher als die Justierelemente 13, so berühren die Justierelemente 13 mit ihren Firstlinien die Fasen 12 entlang derer Flanken, wie es in Figur 3 dargestellt ist. Sind die Fasen 12 niedriger als die Justierelemente 13, so berühren die Justierelemente 13 die oberen Begrenzungskanten der Fasen 12 mit ihren dem Photodetektor 29 zugewandten schrägen Seitenflächen 9, wie es in Figur 4 dargestellt ist. In jedem Fall ist der Photodetektor 29 so bemessen daß er mit seiner Unterfläche auf den quaderförmigen weiteren Justierelementen 14 aufsitzt.

Besteht der Photodetektor z.B. aus Indiumphosphid oder Galliumarsenid, so kann zur Herstellung der Fasen 12 parallel zum Lichtwellenleiter 26 ein Ätzverfahren angewandt werden bei dem z.B. bei Oberflächenausrichtung des Detektorkristalls in (100)-Richtung mit einer HCL-Lösung in (011)-Richtung geätzt wird, was hochpräzise Fasen 12 ergibt. Die Fasen 12 senkrecht zum Lichtwellenleiter 26 können entweder ebenfalls geätzt werden, oder auch mit einer Wafersäge hergestellt werden, wobei beide Verfahren ungenauere Fasen 12 zur Folge haben, da das Verfahren nicht in (011)-Richtung erfolgt, was sich bei der Justierung aber nur in Lichtwellenleiterlängsrichtung auswirkt und somit tolerierbar ist. V-Nuten und somit auch die Fasen 12 können bei Photodetektoren aus Silizium in allen Richtungen geätzt werden. Nach der Positionierung des Photodetektors 29 im Formstempel 10 wird das Flüssig-Polymer über die Anordnung gegossen, welches alle Hohlräume der Anordnung ausfüllt. Dann härtet das Flüssig-Polymer zu einem starren Gebilde aus, das den Deckel 25 bildet. Es ist besonders zweckmäßig, die weiteren Justierelemente zur Unterstützung des Gießvorgangs vielteilig auszuführen.

Zur Herstellung des Deckels 25 sind zwei Verfahrenswege möglich:
1. Nach der Befestigung des Photodetektors 29 an der Trägerplatte 16 wird die Trägerplatte 16 mit der Seite, auf der der Photodetektor 29 befestigt ist, nach oben in eine mit Flüssig-Polymer gefüllte Wanne gelegt.und anschließend der ebenfalls mit Flüssig-Polymer benetzte Formstempel 10 grob vorjustiert in die Wanne gelegt, daß die Justierelemente 13 den vorgesehenen Justiervorgang selbsttätig ausführen. Nach der Aushärtezeit unter der Anwendung eines Anpreßdrucks wird der Formstempel 10 wieder von der Anordnung entfernt. Auch die Trägerplatte 16 kann entfernt werden.
2. Alternativ dazu kann der Formstempel 10 als Boden einer Wanne dienen und der Photodetektor 29 darauf abgesenkt werden. Dann wird das Flüssig-Polymer eingebracht und wieder die Aushärtezeit abgewartet, bevor die Anordnung entformt wird.

Die quaderförmigen weiteren Justierelemente 14 hinterlassen dabei die quaderförmigen Aussparungen 32 im Deckel 25. Die quaderförmigen Aussparungen 32 von den quaderförmigen weiteren Justierelementen 14 dienen beim folgenden Verfahrensschritt des Aufbringens der Verbindungsleitungen 31 als Kontaktlöcher für die Kontaktierung der elektrischen Kontakte 18 des Photodetektors 29. Für diesen Zweck ist es günstig, die Kanten der quaderförmigen weiteren Justierelemente 14 schräg zu gestalten, um einen sicheren elektrischen Kontakt beim Aufbringen des Verbindungsleitungsmaterials zu gewährleisten. Das Aufbringen der Verbindungsleitungen 31 nach dem Entformen des Deckels 25 erfolgt zweckmäßigerweise mit einem photolithographischen Ätzverfahren und nachfolgender Metallbeschichtung, z.B. Sputtern. Die dachförmigen Erhebungen 15 hinterlassen nach dem Entformen die weiteren V-förmigen Nuten 28 in der Deckelplatte 27, welche zur Aufnahme und Justierung der einzulegenden Glasfasern 34 beim Zusammenbau der integriert optischen Schaltung dienen. Nach der Herstellung des Deckels 25 kann zum Zusammenbau der integriert optischen Schaltung der Deckel 25 mittels des Klebers 24 auf das Substrat 20 geklebt werden, wobei gleichzeitig die Glasfasern 34 in die vorgesehenen V-förmigen Nuten 22, 28 eingelegt werden und ebenfalls mittels des Klebers 24 mechanisch und optisch an der Anordnung aus Deckel 25 und Substrat 20 befestigt werden. Die beim Formvorgang in der Deckelplatte 27 zurückbleibenden invers-eckdachförmigen Vertiefungen 35 in Form der inversen Justierelemente 13 werden beim Verbinden von Deckel 25 und Substrat 20 für die integriert optische Schaltung vom Kleber 24 ausgefüllt und haben keine weitere Funktion. Die von den quaderförmigen weiteren Justierelementen 14 nach dem Entformen in der Deckelplatte 27 hinterlassenen quaderförmigen Aussparungen 32, durch die im nächsten Verfahrensschritt die elektrischen Kontakte 18 mit den Verbindungsleitungen 31 verbunden wurden, werden beim nachfolgenden, dem Zusammenbau der integriert optischen Schaltung dienenden, Kleben mit dem Kleber 24 gefüllt.

Figur 5 zeigt einen Querschnitt durch die integriert optische Schaltung mit dem Deckels 25 auf dem Substrat 20 unter Verwendung einer Zusatzplatte 17. Auf dem Substrat 20, welches den Lichtwellenleiter 26 enthält, ist der Deckel 25 aufgeklebt. Er enthält den Photodetektor 29, der in die Deckelplatte 27 eingebettet ist und auf seiner Oberseite mit der Zusatzplatte 17 verbunden ist. Die Zusatzplatte 17 ist mit ihrer Oberseite an der Trägerplatte 16 befestigt. Die Absorptionszone 30 an der Unterseite des Photodetektors 29 ist durch die Teilschicht 33 vom Substrat 20 getrennt. Die elektrischen Kontakte 18 sind mit den Verbindungsleitungen 31, welche durch die quaderförmigen Aussparungen 32, die durch die quaderförmigen weiteren Justierelemente 14 im Deckel 25 entstanden sind, verlaufen, verbunden. Die Verbindungsleitungen 31 verlaufen weiter zwischen Deckel 25 und Substrat 20 nach außen. Die Trägerplatte 16 wurde hier nach dem Erstarren des Flüssig-Polymers nicht von der Anordnung entfernt. Die Zusatzplatte 17 zwischen Photodetektor 29 und Trägerplatte 16 ist in ihren Außenabmessungen größer als der Photodetektor 29 und kleiner als die Trägerplatte 16. Die Zusatzplatte 17 dient der Verdickung des Deckels 25, der dadurch mechanisch stabiler wird.

Für eine verbesserte Funktion ist es möglich, die Unterseite des Photodetektors 29 möglichst großflächig zu metallisieren, um ein Eindringen des im Lichtwellenleiter 26 geführten elektromagnetischen Feldes in den Photodetektor 29 zu verhindern, da dies erhöhte Wellenleiterverluste bedeuten würde. Da aber die Metallisierung andererseits störenden Einfluß auf die Ausbreitung des Lichts im Lichtwellenleiter 26 hat, ist es sinnvoll, den Abstand zwischen der Metallisierung des Photodetektors 29 und dem Lichtwellenleiter 26 zu vergrößern. Dies ist möglich, indem die Höhe der weiteren Justierelemente 14 vergrößert wird. Um den damit auch vergrößerten Abstand zwischen der Absorptionszone 30 und dem Lichtwellenleiter 26 auszugleichen, ist es zweckmäßig, wenn der Photodetektor 29 auf der zwischen den weiteren Justierelementen 14 liegenden Fläche der Unterseite auf der sich auch die Absorptionszone 30 befindet, eine Erhöhung aufweist, die vorzugsweise aus dem gleichen Material besteht, wie der Photodetektor 29 und die Aufgabe hat, aufgrund ihres höheren Brechungsindizes die Auskopplung des Lichts aus dem Lichtwellenleiter 29 zur Absorptionszone 30 zu verbessern.

Als weitere Anwendung ist die Integration eines weiteren optischen Bauelements 36 in Form eines thermischen Aktors vorgesehen.Auch hier wird die Justierung des thermischen Aktors 36 bereits beim Herstellen des Deckels 25, in den der thermische Aktor 36 integriert werden soll, mittels des Formstempels 10 vorgenommen. Der Aufbau des Substrats 20, sowie die Anordnung der Glasfasern 34 und des Lichtwellenleiters 26 ist daher gleich dem oben beschriebenen.

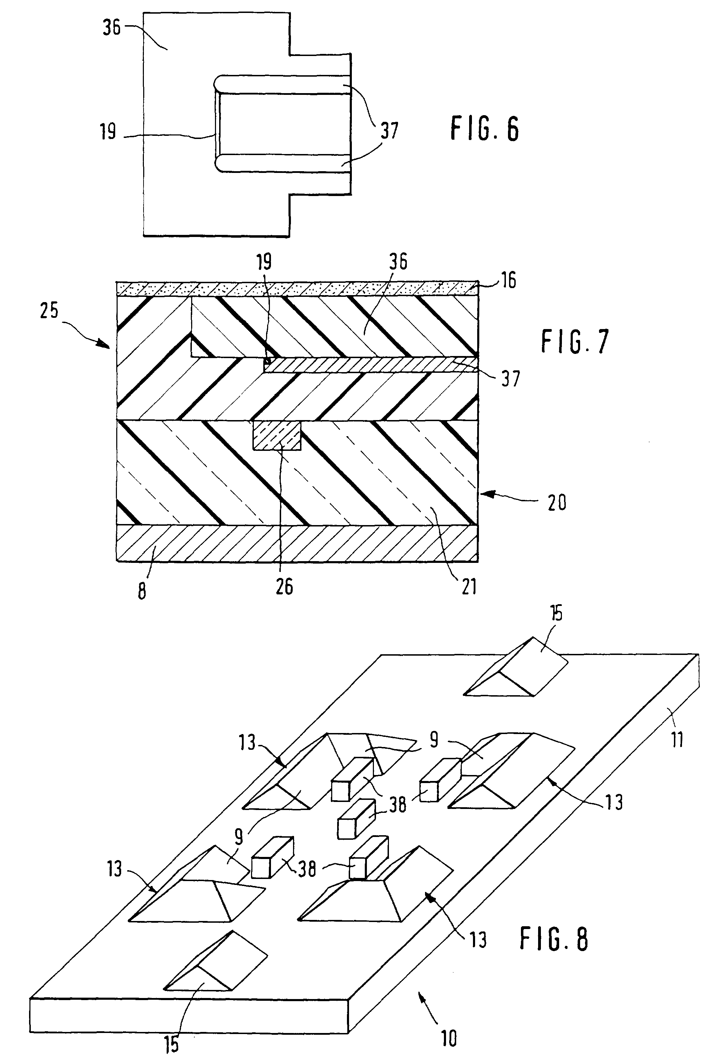

In Figur 6 ist ein thermischer Aktor 36 mit einem Heizdraht 19 in einer unteren Draufsicht dargestellt. Der Heizdraht 19 ist auf der Unterseite des thermischen Aktors 36 befestigt, besitzt zwei weitere elektrische Kontakte 37 als Anschlüsse und dient der thermischen Ansteuerung des thermisch empfindlichen aus dem Kleber 24 gebildeten Lichtwellenleiters 26.

Figur 7 zeigt einen Querschnitt durch eine Anordnung aus Substrat 20 und Deckel 25 mit thermischem Aktor 36 mit dem Heizdraht 19. Der thermische Aktor 36 ist mit seiner Oberseite an der Trägerplatte 16 befestigt und weist an seiner Unterseite die weiteren elektrischen Kontakte 37 und den Heizdraht 19 auf. Der Heizdraht 19 kommt bei aufgeklebtem Deckel 25 genau über dem Lichtwellenleiter 26 zu liegen. Auf der Unterseite ist das Substrat 20 mit einer Kühlplatte 8 verbunden.

Durch den Heizdraht 19 fließender Strom ergibt eine Wärmeentwicklung, wodurch der Heizdraht 19 seine nächste Umgebung, insbesondere den Lichtwellenleiter 26, erwärmt. Zur Abführung der Wärme ist die als Wärmesenke dienende Kühlplatte 8 vorgesehen, die an der Unterseite des Substrats 20 thermisch leitfähig befestigt ist. Es ist ebenso möglich die Kühlplatte 8 auf der Oberseite des Deckels 25 thermisch leitfähig zu befestigen. Durch die Integration des thermischen Aktors 36 in den Verlauf des mittels Glasfasern 34 und Lichtwellenleiter 26 geführten Lichts kann ein Lichtsignal im Lichtwellenleiter 26 thermooptisch verändert werden, da der Lichtwellenleiter 26 einen temperaturabhängigen Brechungsindex aufweist.

Figur 8 enthält die perspektivische Darstellung des Formstempels 10 zur Herstellung des Deckels 25 mit thermischem Aktor 36 mit Heizdraht 19. Der Formstempel 10 in Figur 7 unterscheidet sich vom Formstempel 10 in Figur 2 lediglich durch die Anordnung und Form der quaderförmigen weiteren Justierelemente 14. Der Formstempel 10 weist hier anstelle der quaderförmigen weiteren Justierelemente 14 Abstandshalter 38 auf, die in einer Würfel-Fünf-Formation auf der Oberfläche der Grundplatte 11 innerhalb des von den eckdachförmigen Justierelementen 13 gebildeten Rechtecks angeordnet sind. Da im Falle der Integration eines thermischen Aktors mit Heizdraht 19 geringere Anforderungen an die Exaktheit der Justierung des Heizdrahts 19 in vertikaler Richtung bestehen, genügen hier einfache aufgeklebte Blechscheiben oder auch galvanisch aufgewachsene Erhöhungen als Abstandshalter 38.

## Patentansprüche

1. Verfahren zum Herstellen eines Deckels für eine integriert-optische Schaltung, in dem
a.) ein Formstempel (10) bereitgestellt wird, der mit ersten Justierelementen (13) versehen ist, wobei
b.) der Formstempel (10) zweite Justierelemente (15) aufweist,
c.) auf den Formstempel (10) ein optisches Bauelement (29) aufgelegt wird, das durch die ersten Justierelemente (13) mikrometergenau lateral fixiert wird,
d.) der Deckel (25) durch Gießen einer aushärtbaren Flüssigkeit um das optische Bauelement (29) und die zweiten Justierelemente (15) herum und anschließendes Entformen vom Formstempel hergestellt wird,
wobei durch den Abdruck der zweiten Justierelemente (15) eine mikrometergenaue Fixiermöglichkeit relativ zum optischen Bauelement (29) für ein weiteres Bauelement, insbesondere eine optische Faser oder ein Substrat für eine integriert-optische Schaltung, im Deckel (25) erzeugt wird.

2. Verfahren nach Anspruch 1, dadurch gekennzeichnet, daß das optische Bauelement (29) und die Justierelemente (13,15) zumindest teilweise mit schrägen Seitenflächen versehen werden.

3. Verfahren nach Anspruch 1 oder 2, dadurch gekennzeichnet, daß der Formstempel (10) mit weiteren Justierelementen (14) versehen wird.

4. Verfahren nach einem der Ansprüche 1 bis 3, dadurch gekennzeichnet, daß der Formstempel (10) mit Formelementen zur Erzeugung einer Bragg-Struktur versehen wird.

5. Verfahren nach Anspruch 3 oder 4, dadurch gekennzeichnet, daß nach dem Entformen des Formstempels (10) elektrisch leitfähiges Material auf Teilflächen der Unterseite des Dekkels (25) aufgebracht wird und daß durch die mittels der weiteren Justierelemente (14) hergestellten Aussparungen (32) Kontaktierungen zwischen dem optischen Bauelement (29) und Verbindungsleitungen (31) gebildet werden.

6. Verfahren nach einem der Ansprüche 1 bis 5, dadurch gekennzeichnet, daß das optische Bauelement (29) vor dem Auflegen auf den Formstempel (10) mit seiner Oberseite an einer Trägerplatte (16) befestigt wird.

7. Verfahren nach Anspruch 6, dadurch gekennzeichnet, daß zwischen dem optischen Bauelement (29) und der Trägerplatte (16) eine Zusatzplatte angeordnet wird.

## Claims

1. Method for producing a cover for an integrated optical circuit, in which
a.) a mould punch (10) is provided, which is provided with first alignment elements (13),
b.) the mould punch (10) having second alignment elements (15),
c.) an optical component (29) is placed onto the mould punch (10) and is laterally fixed by the first alignment elements (13) with micrometer accuracy,
d.) the cover (25) is produced by casting a curable liquid around the optical component (29) and the second alignment elements (15) and by subsequent release from the mould punch,
the impression of the second alignment elements (15) producing a fixing possibility with micrometer accuracy relative to the optical component (29) for a further component, in particular an optical fibre or a substrate for an integrated optical circuit, in the cover (25).

2. Method according to Claim 1, characterized in that the optical component (29) and the alignment elements (13, 15) are provided at least partially with oblique side faces.

3. Method according to Claim 1 or 2, characterized in that the mould punch (10) is provided with further alignment elements (14).

4. Method according to one of Claims 1 to 3, characterized in that the mould punch (10) is provided with mould elements for producing a Bragg structure.

5. Method according to Claim 3 or 4, characterized in that after the release from the mould punch (10), electrically conductive material is applied to partial areas of the underside of the cover (29), and in that contacts between the optical component (29) and connecting lines (31) are formed by the cutouts (32) produced by means of the further alignment elements (14).

6. Method according to one of Claims 1 to 5, characterized in that the optical component (29) is fastened by its top side to a carrier plate (16) before being placed onto the mould punch (10).

7. Method according to Claim 6, characterized in that an additional plate is arranged between the optical component (29) and the carrier plate (16).

## Revendications

1. Procédé de fabrication d'un couvercle pour un circuit optique intégré selon lequel :
a) on utilise un pavé de moulage (10) équipé de premiers éléments d'ajustage (13),
b) le pavé de moulage (10) comportant des seconds éléments d'ajustage (15),
c) sur le pavé de moulage (10) on applique un composant optique (29) bloqué latéralement à la précision du micron par les premiers éléments d'ajustage (13),
d) on réalise le couvercle (25) en coulant un liquide durcissable autour du composant optique (29) et les autres éléments d'ajustage (15) puis on démoule par rapport au pavé de moulage,
par l'empreinte des seconds éléments d'ajustage (15) on génère une possibilité de fixation à la précision du micron par rapport au composant optique (29) pour un autre composant notamment une fibre optique ou un substrat pour un circuit optique intégré dans le couvercle (25).

2. Procédé selon la revendication 1,
caractérisé en ce que
le composant optique (29) et les éléments d'ajustage (13, 15) sont munis au moins partiellement de côtés inclinés.

3. Procédé selon la revendication 1 ou 2,
caractérisé en ce que
le pavé de moulage (10) est muni d'autres éléments d'ajustage (14).

4. Procédé selon l'une des revendications 1 à 3,
caractérisé en ce que
le pavé de moulage (10) est muni d'éléments de moulage pour réaliser une structure de Bragg.

5. Procédé selon la revendication 3 ou 4,
caractérisé en ce qu'
après le démoulage du pavé de moulage (10), on applique la matière conductrice d'électricité sur des surfaces partielles du côté inférieur du couvercle (25) et à l'aide des découpes (32) réalisées au moyen des autres éléments d'ajustage (14) on forme des contacts entre le composant optique (29) et les lignes de liaison (31).

6. Procédé selon l'une des revendications 1 à 5,
caractérisé en ce que
le composant optique (29) est fixé avec son côté supérieur sur une plaque de support (16) avant d'être placé sur le pavé de moulage (10).

7. Procédé selon la revendication 6,
caractérisé en ce qu'
on utilise une plaque complémentaire entre le composant optique (29) et la plaque de support (16).
